Europäisches Patentamt

European Patent Office

Office européen des brevets

(11) Numéro de publication: **0 414 114 A1**

# DEMANDE DE BREVET EUROPEEN

(21) Numéro de dépôt: 90115634.9

(22) Date de dépôt: 16.08.90

(51) Int. Cl.5: **H03D 7/00**, H03H 19/00

(30) Priorité: 21.08.89 FR 8911152

(43) Date de publication de la demande:
27.02.91 Bulletin 91/09

(84) Etats contractants désignés:
**CH DE FR GB IT LI NL SE**

(71) Demandeur: **ASULAB S.A.**
**Faubourg du Lac 6**
**CH-2501 Bienne(CH)**

(72) Inventeur: **Margairaz, Jacques**
**Faubourg de l'Hopital 14**
**CH-2000 Neuchatel(CH)**
Inventeur: **Farine, Pierre-André**
**Port-Roulant 12a**
**CH-2003 Neuchatel(CH)**
Inventeur: **Beck, Daniel**
**Chemin de Charcottet 24**
**CH-2022 Bevaix(CH)**

(74) Mandataire: **de Montmollin, Henri et al**
**ICB Ingénieurs Conseils en Brevets SA**
**Passage Max Meuron 6**
**CH-2001 Neuchâtel(CH)**

(54) Circuit récepteur.

(57) Le circuit récepteur (1) comporte un circuit d'antenne destiné à fournir un signal d'antenne ayant une première fréquence Fo, un oscillateur local (7) destiné à fournir un signal d'oscillateur ayant une deuxième fréquence Flo, un circuit mélangeur (6) destiné à fournir un signal de mélange en réponse au signal d'antenne et au signal d'oscillateur, un circuit (10) destiné à fournir un signal d'horloge ayant une troisième fréquence Fck égale à Flo/N où N est un premier facteur constant, et un filtre à échantillonnage (9) destiné à filtrer le signal de mélange et ayant une fréquence caractéristique Fc égale à Fck/K où K est un deuxième facteur constant.

Pour simplifier la construction de ce récepteur (1), l'oscillateur local (7) est agencé de manière que $Flo = K \cdot N/(K \cdot N \pm 1)$.

Application aux récepteurs des recherches de personnes.

## CIRCUIT RECEPTEUR

La présente invention a pour objet un circuit récepteur comportant un circuit d'antenne destiné à fournir un signal d'antenne ayant une première fréquence, un oscillateur local destiné à fournir un signal d'oscillateur ayant une deuxième fréquence, un circuit mélangeur destiné à fournir un signal de mélange en réponse au signal d'antenne et au signal d'oscillateur, des moyens destinés à fournir un signal d'horlogerie ayant une troisième fréquence égale au quotient de la deuxième fréquence par un premier facteur constant, et un filtre à échantillonnage destiné à filtrer le signal de mélange en réponse au signal d'horloge et ayant une fréquence caractéristique égale au quotient de la troisième fréquence par un deuxième facteur constant.

De tels récepteurs sont de plus en plus miniaturisés grâce aux progrès réalisés dans les techniques de fabrication des circuits intégrés. Cette miniaturisation a en outre été facilitée par le fait que le filtre qui fait partie, dans ces récepteurs, du circuit basse fréquence, est un filtre à échantillonnage dont les composants peuvent être réalisés dans le même circuit intégré que les autres éléments de ces récepteurs.

Les filtres à échantillonnage sont bien connus et ne seront pas décrits ici.

On rappellera simplement qu'il en existe deux types principaux, les filtres numériques et les filtres à capacités commutées. En général, seuls ces derniers sont utilisés dans les récepteurs, du fait que les filtres numériques comportent plus de composants et nécessitent en outre la présence d'un convertisseur analogique / numérique.

On rappellera également que ces filtres à échantillonnage nécessitent un signal d'horloge pour leur fonctionnement.

Pour une configuration donnée du filtre à échantillonnage, la fréquence de ce signal d'horloge détermine la fréquence caractéristique de ce filtre, c'est-à-dire sa fréquence de coupure dans le cas d'un filtre passe-bas ou passe-haut, ou sa fréquence centrale dans le cas d'un filtre passe-bande. En général, cette fréquence du signal d'horloge doit être huit à dix fois supérieure à cette fréquence caractéristique du filtre.

Les récepteurs connus comportent donc généralement deux oscillateurs. Le premier de ceux-ci, qui est généralement appelé oscillateur local, est utilisé pour produire un signal de référence destiné à être mélangé au signal modulé fourni par le circuit d'antenne. Le deuxième de ces oscillateurs est destiné à fournir le signal d'horloge qui est nécessaire au fonctionnement du filtre à échantillonnage comme cela a été rappelé ci-dessus.

Dans les cas où ces récepteurs connus doivent pouvoir capter sélectivement les émissions de plusieurs émetteurs ayant des fréquences d'émission, ou fréquences porteuses, différentes, l'oscillateur local doit être conçu de manière que la fréquence du signal de référence qu'il fournit puisse être modifiée en même temps que la fréquence de résonance du circuit d'antenne.

Dans d'autres cas, notamment dans les systèmes de recherche de personne, où les récepteurs sont destinés à ne recevoir que les émissions d'un seul émetteur ayant une fréquence porteuse fixe, l'oscillateur local doit fournir un signal de référence dont la fréquence est également fixe. Dans ce cas, l'oscillateur local comporte généralement un résonateur en quartz dont les caractéristiques déterminent la fréquence du signal fourni par cet oscillateur.

Le deuxième des oscillateurs mentionnés ci-dessus comporte généralement aussi un résonateur en quartz dont les caractéristiques déterminent la fréquence du signal d'horloge appliqué au filtre à échantillonnage.

La présence de ces deux oscillateurs, et plus particulièrement des composants de ceux-ci qui ne peuvent pas être réalisés dans un circuit intégré, comme par exemple les condensateurs variables et/ou les résonateurs en quartz, est un obstacle à la miniaturisation poussée du récepteur, complique la fabrication de celui-ci, augmente à la fois son prix de revient et les risques qu'il tombe en panne ainsi que le nombre de réglages qui doivent être faits à la mise en service du récepteur.

Le brevet US-A-4 484 358 décrit un récepteur dans lequel ces inconvénients sont évités grâce au fait que le signal d'horloge appliqué au filtre à échantillonnage est créé par un circuit de mise en forme à partir du signal à fréquence intermédiaire fourni par le circuit mélangeur. Ce récepteur connu présente l'inconvénient que le circuit de mise en forme est un circuit analogique dont la présence augmente le nombre de composants du récepteur et dont la consommation est assez élevée.

La demande de brevet JP-A-60-223335 décrit également un récepteur dans lequel les inconvénients ci-dessus sont évités grâce au fait que ce récepteur ne comporte qu'un seul oscillateur, et que le signal fourni par cet oscillateur a une fréquence fixe.

Dans ce récepteur, le signal d'horloge appliqué au filtre à échantillonnage est fourni par un circuit diviseur dont l'entrée est reliée à l'oscillateur mentionné ci-dessus, et la fréquence de ce signal d'horlogerie est donc fixe, de même que la fréquence caractéristique de ce filtre.

En outre, le signal de référence appliqué au circuit mélangeur est fourni par un circuit à boucle de blocage de phase, qui est programmable de manière que, quelle que soit la fréquence du signal fourni par le circuit d'antenne, la fréquence du signal de mélange soit égale à la fréquence centrale du filtre à échantillonnage.

Ce circuit à boucle de blocage de phase programmable est un circuit relativement compliqué dont la consommation est importante et qui comporte notamment un oscillateur à fréquence asservie par une tension et un filtre passe-bas qui sont des circuits analogiques dont certains composants ne peuvent que difficilement être réalisés par les techniques classiques de fabrication des circuit intégrés.

Un but de la présente invention est de proposer un circuit récepteur qui ne présente pas les inconvénients des récepteurs connus, c'est-à-dire qui ne comporte qu'un seul oscillateur et dans lequel la plupart des autres circuits sont des circuits de type numérique dont la consommation peut être très faible.

Ce but est atteint par le circuit récepteur revendiqué, qui comporte un circuit d'antenne destiné à fournir un signal d'antenne ayant une première fréquence, un oscillateur local destiné à fournir un signal d'oscillateur ayant une deuxième fréquence, un circuit mélangeur destiné à fournir un signal de mélange en réponse au signal d'antenne et au signal d'oscillateur, des moyens destinés à fournir un signal d'horloge ayant une troisième fréquence égale au quotient de la deuxième fréquence par un premier facteur constant, et un filtre à échantillonnage destiné à filtrer le signal de mélange en réponse au signal d'horloge et ayant une fréquence caractéristique égale au quotient de la troisième fréquence par un deuxième facteur constant, ce récepteur étant caractérisé par le fait que l'oscillateur local est agencé de manière que la deuxième fréquence soit égale au produit de la première fréquence par un troisième facteur constant égal à $K \cdot N/(K \cdot N \pm 1)$, où N et K sont respectivement égaux au premier et au deuxième facteur constant.

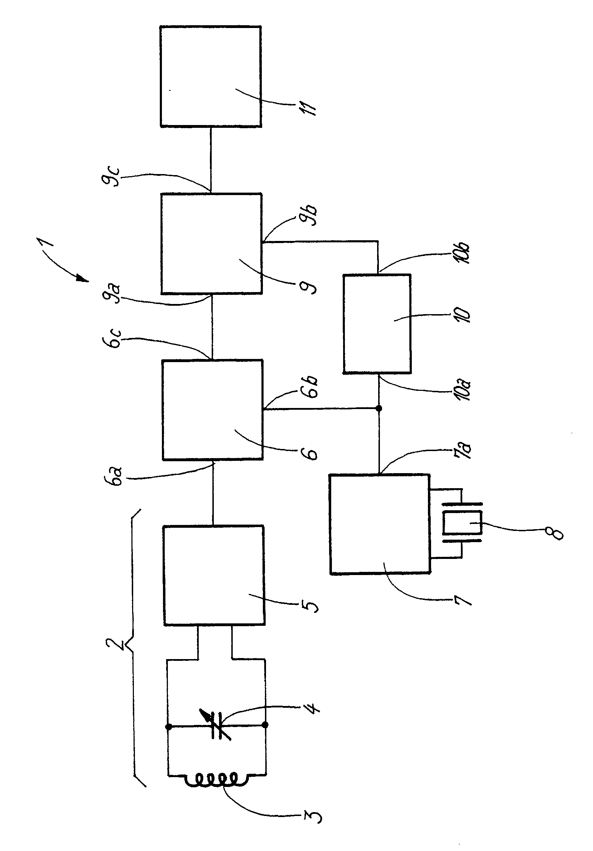

L'invention va être décrite ci-dessous à l'aide du dessin annexé dans lequel la figure unique représente à titre d'exemple non limitatif le schéma-bloc d'une forme d'exécution d'un récepteur selon l'invention.

Dans cet exemple, ce récepteur, qui est désigné par la référence 1, fait partie d'une installation de recherche de personnes. Il est donc destiné à recevoir des signaux ayant une fréquence porteuse fixe et prédéterminée. Mais il sera rendu évident par la suite de cette description qu'il pourrait tout aussi bien être destiné à capter sélectivement des signaux ayant des fréquences porteuses différentes les unes des autres.

Le récepteur 1 comporte un circuit d'antenne 2 comprenant une antenne 3, un condensateur d'accord 4 et un amplificateur 5. Dans l'exemple représenté, le condensateur 4 est un condensateur variable, mais on verra plus loin que dans certains cas il peut également être un condensateur fixe.

Le signal fourni par ce circuit d'antenne 2 a une fréquence porteuse déterminée par les caractéristiques de l'antenne 3 et du condensateur d'accord 4, fréquence qui est évidemment égale à la fréquence porteuse du signal produit par l'émetteur que le récepteur est destiné à capter. Cette fréquence sera désignée par Fo dans la suite de cette description.

Le récepteur 1 comporte également un circuit mélangeur 6 dont l'entrée 6a reçoit le signal fourni par le circuit d'antenne 2 et dont l'entrée 6b reçoit le signal de référence produit par un oscillateur local 7 comprenant un résonateur en quartz 8. La fréquence de ce signal de référence est déterminée principalement par les caractéristiques du résonateur 8, et elle sera appelée fréquence Flo dans la suite de cette description.

De manière bien connue, le signal de mélange produit par la sortie 6c du circuit mélangeur 6 comporte un grand nombre de composantes. La seule de ces composantes qui soit utile est celle dont la fréquence centrale, qui sera désignée par Fm dans la suite de cette description, est égale à la valeur absolue de la différence entre la fréquence Fo du signal fourni par le circuit d'antenne 2 et la fréquence Flo du signal de référence produit par l'oscillateur local 7.

Les autres composantes du signal de mélange sont éliminées, de manière bien connue, par un filtre à échantillonnage 9, qui est dans le présent exemple un filtre passe-bande à capacités commutées, dont l'entrée 9a est reliée à la sortie 6c du circuit mélangeur 6. Le signal d'horloge nécessaire au fonctionnement du filtre 9 est fourni à son entrée 9b par la sortie 10b d'un circuit diviseur de fréquence 10 dont l'entrée 10a est reliée à la sortie 7a de l'oscillateur local 7, comme l'entrée 6b du circuit mélangeur 6. La fréquence de ce signal d'horloge, qui sera désignée par Fck, est donc égale au rapport entre la fréquence Flo du signal produit par l'oscillateur local 7 et le taux de division du circuit diviseur 10, taux qui sera désigné par N dans la suite de cette description.

En outre, de manière bien connue, la fréquence centrale du filtre passe-bande 9, qui sera désignée par Fc, est égale au rapport entre la fréquence d'horloge Fck et un facteur K qui dépend de la constitution de ce filtre 9.

Le signal filtré présent à la sortie 9c du filtre 9 est appliqué à l'entrée d'un circuit basse fréquence 11 comprenant notamment, dans le présent exemple, un redresseur et un circuit décodeur capable de reconnaître le code particulier attribué au récepteur dont il fait partie et de déclencher l'émission d'un signal sonore en réponse à la réception de ce code.

Les divers circuits et composants qui viennent d'être énumérés ne seront pas décrits en détail car ils sont tout à fait classiques et sont bien connus des spécialistes. On notera simplement que, de préférence, l'amplificateur 5, le circuit mélangeur 6, l'oscillateur 7, le filtre 9, le diviseur de fréquence 10 et le circuit basse fréquence 11 sont réalisés dans un seul et même circuit intégré.

Pour que le récepteur 1 qui vient d'être décrit fonctionne correctement, il faut bien entendu que la fréquence centrale Fc du filtre 9 soit égale à la fréquence centrale Fm de la composante utile du signal de mélange.

Or, comme on l'a vu ci-dessus, la fréquence Fm est égale à la valeur absolue de la différence entre la fréquence Fo du signal fourni par le circuit d'antenne 2 et la fréquence Flo du signal de référence fourni par l'oscillateur local 7.

L'équation

$$Fc = |Fo - Flo| \qquad (1)$$

doit donc être vérifiée.

D'autre part, la fréquence centrale Fc du filtre 9 est donnée par l'équation

$$Fc = \frac{1}{K} \cdot Fck,$$

qui peut également s'écrire

$$Fc = \frac{1}{K \cdot N} \cdot Flo \qquad (2)$$

puisque

$$Fck = \frac{1}{N} \cdot Flo$$

En combinant les équations 1 et 2 ci-dessus, on voit facilement que la condition de fonctionnement posée par l'équation 1 est remplie lorsque

$$Flo = \frac{K \cdot N}{K \cdot N \pm 1} \cdot Fo \qquad (3)$$

Cette équation 3 montre que, quels que soient les choix qui sont faits pour les valeurs de K et de N, il est toujours possible de déterminer, pour chaque valeur de la fréquence Fo, deux valeurs distinctes de la fréquence Flo (l'une inférieure et l'autre supérieure à cette fréquence Fo) pour lesquelles la condition de fonctionnement posée ci-dessus est remplie.

Cela signifie qu'il est toujours possible de réaliser un récepteur selon la présente invention qui a l'avantage par rapport à la plupart des récepteurs connus de ne pas comporter d'oscillateur spécialement affecté à la fourniture du signal d'horloge du filtre à échantillonnage.

L'absence de ce dernier oscillateur dans les récepteurs selon l'invention, et surtout l'absence des composants de cet oscillateur qui ne peuvent pas être réalisés dans un circuit intégré, augmente les possibilités de miniaturisation de ces récepteurs, simplifie leur fabrication et diminue donc à la fois leur prix de revient et les risques qu'ils tombent en panne.

En outre, par rapport aux récepteurs connus décrits dans le brevet US-A-4 484 358 ou dans la demande de brevet JP-A-60-223335 mentionnés ci-dessus, le récepteur selon l'invention a l'avantage qu'il ne nécessite aucun circuit analogique pour fournir le signal d'horloge nécessaire au fonctionnement de son filtre à échantillonnage ou pour fournir le signal de référence appliqué à son circuit mélangeur, et que tous ses composants, à l'exception bien sûr de son antenne 3, de son condensateur d'accord 4 et de son résonateur 8, peuvent être très facilement réalisés dans un seul et même circuit intégré dont la consommation d'énergie électrique est très faible.

Il faut noter que l'absence déjà mentionnée d'un oscillateur spécialement affecté à la fourniture du signal d'horloge du filtre à échantillonnage dans les récepteurs selon l'invention a pour conséquence, comme cela ressort des équations ci-dessus, que la fréquence centrale Fc de ce filtre dépend de la fréquence centrale Fo du signal que ces récepteurs sont destinés à capter. Cette fréquence centrale Fc du filtre à échantillonnage peut donc être différente d'un récepteur à l'autre. Cette différence n'a cependant aucune conséquence, puisque quelle que soit cette fréquence centrale Fc, elle est automatiquement égale à la fréquence centrale Fm de la composante du signal de mélange que le filtre à échantillonnage doit sélectionner.

On voit que, lorsque le récepteur 1 fait partie d'une installation de recherche de personnes, il suffit de l'équiper, ainsi bien entendu que tous les autres récepteurs faisant partie de la même installation, d'un résonateur en quartz 8 choisi de manière que l'oscillateur local 7 produise un signal ayant l'une des deux fréquences qui peuvent être calculées à l'aide de l'équation 3 ci-dessus pour la fréquence porteuse du signal émis par l'émetteur de l'installation. En outre, dans un tel cas, le condensateur d'accord 4 du circuit d'antenne 2 peut être un condensateur fixe puisque cette fréquence porteuse est elle-même fixe.

Dans le cas où le récepteur selon l'invention est destiné à recevoir, sélectivement, des signaux produits par plusieurs émetteurs distincts avec des fréquences porteuses différentes, il suffit de coupler, par exemple mécaniquement, le condensateur d'accord 4 du circuit d'antenne 2 avec l'élément déterminant la fréquence du signal produit par l'oscillateur local 7, élément qui n'est évidemment pas, dans ce cas, un résonateur en quartz mais qui est généralement un autre condensateur variable. Ce couplage entre le condensateur d'accord 2 et cet élément déterminant la fréquence du signal produit par l'oscillateur local 7 doit bien entendu être réalisé de manière que cette dernière fréquence corresponde, pour chaque fréquence porteuse, à celle qui peut être déterminée à l'aide de l'équation 3 ci-dessus.

Il faut encore noter que, pour des raisons de simplicité évidentes, on choisira de préférence, pour le taux de division N du diviseur de fréquence 10, une valeur égale à une des puissances entières de 2, telles que 2, 4, 8 etc.

Il faut également noter que ce diviseur de fréquence 10 n'est pas absolument indispensable, et que l'on peut très bien relier l'entrée d'horloge 9b du filtre à échantillonnage 9 directement à la sortie 7a de l'oscillateur local 7. Dans ce cas, le facteur N des équations ci-dessus et évidemment égal à 1 et la fréquence Flo du signal que l'oscillateur local doit produire pour que la condition de fonctionnement ci-dessus soit remplie est alors donnée par $Flo = \frac{K}{K \pm 1} \cdot Fo$ (4)

Cependant, comme la quantité d'énergie électrique consommée par le filtre à échantillonnage 9 est directement proportionnelle à la fréquence du signal d'horloge appliqué à son entrée 9b, on ne choisira de préférence pas une telle solution dans les cas où les dimensions, et donc la capacité, de la source fournissant cette énergie électrique sont limitées, c'est-à-dire notamment dans les cas où l'amplificateur 1 fait partie d'un dispositif portable.

En effet, la diminution de la consommation d'énergie électrique par le filtre 9 due à l'abaissement de la fréquence de son signal d'horloge causée par la présence du diviseur 10 est nettement supérieure à la quantité d'énergie électrique consommée par ce dernier, surtout si ce diviseur est réalisé à l'aide de transistors MOS complémentaires.

D'autre part, il est bien connu que la variation de l'amplitude d'un signal transmis par un filtre à échantillonnage en fonction de la fréquence de ce signal est d'autant plus rapide, de part et d'autre de la fréquence centrale de ce filtre, que la fréquence du signal d'horloge appliqué à ce dernier est basse. Comme on cherche en général à rendre cette variation aussi rapide que possible pour améliorer le filtrage du signal produit par le circuit mélangeur 6, on voit qu'il est avantageux, de ce point de vue également, de ne pas relier directement l'entrée d'horloge 9b du filtre à échantillonnage 9 à la sortie 7a de l'oscillateur local 7, mais d'intercaler le circuit diviseur de fréquence 10 entre cette entrée et cette sortie.

## Revendications

1. Circuit récepteur comportant :
- un circuit d'antenne (2) destiné à fournir un signal d'antenne ayant une première fréquence;
- un oscillateur local (7) destiné à fournir un signal d'oscillateur ayant une deuxième fréquence;
- un circuit mélangeur (6) destiné à fournir un signal de mélange en réponse audit signal d'antenne et audit signal d'oscillateur;
- des moyens (10) destinés à fournir un signal d'horloge ayant une troisième fréquence égale au quotient de ladite deuxième fréquence par un premier facteur constant; et
- un filtre à échantillonnage (9) destiné à filtrer ledit signal de mélange en réponse audit signal d'horloge et ayant une fréquence caractéristique égale au quotient de ladite troisième fréquence par un deuxième facteur constant;
caractérisé par le fait que ledit oscillateur local (7) est agencé de manière que ladite deuxième fréquence soit égale au produit de ladite première fréquence par un troisième facteur constant égal à $K \cdot N/(K \cdot N \pm 1)$, où N et K sont respectivement égaux audit premier et audit deuxième facteur constant.

2. Circuit récepteur selon la revendication 1, caractérisé par le fait que lesdits moyens destinés à produire ledit signal d'horloge comportent un circuit diviseur de fréquence (10) dont l'entrée est reliée à la sortie dudit oscillateur local, dont la sortie fournit ledit signal d'horloge et dont le taux de division est égal audit premier facteur constant.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A,D | PATENT ABSTRACTS OF JAPAN, vol. 010079, groupe E391, 28 mars 1986; & JP-A-60 223 335 (HITACHI SEISAKUSHO) 07-11-1985 * Résumé en entier * | 1,2 | H 03 D    7/00 H 03 H   19/00 |
| A | IEEE JOURNAL OF SOLID-STATE CIRCUITS, vol. SC-22, no. 6, décembre 1987, pages 1147-1154; B.-S. SONG: "A narrow-band CMOS FM receiver based on single-sideband modulation IF filtering" * Page 1149, colonne de droite, lignes 2-33; figure 2 * | 1,2 | |
| A,D | GB-A-2 118 793   (NIPPON ELECTRIC) | | |
| A | US-A-4 295 105   (J.A.C. BINGHAM) | | |

DOMAINES TECHNIQUES RECHERCHES (Int. Cl.5)

H 03 D
H 04 B
H 03 H

Le présent rapport a été établi pour toutes les revendications

| Lieu de la recherche | Date d'achèvement de la recherche | Examinateur |
|---|---|---|
| LA HAYE | 28-11-1990 | DHONDT I.E.E. |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
 
& : membre de la même famille, document correspondant

EPO FORM 1503 03.82 (P0402)